# DEMANDE DE BREVET EUROPEEN

(11) **EP 1 031 844 A2**
(43) Date de publication de la demande: **30.08.2000**
(21) Numéro de dépôt: 00810067.9
(22) Date de dépôt: 25.01.2000
(51) Int. Cl.: G01R 33/07, G01R 15/20

(54) **Procédé de fabrication d'un capteur de courant électrique**

(30) Priorité: 25.02.1999 CH 35099
(71) Demandeur: LIAISONS ELECTRONIQUES-MECANIQUES LEM S.A., CH-1228 Plan-les-Ouates (CH)
(72) Inventeur: Blanchard, Hubert, 1800 Vevey (CH)
(74) Mandataire: WILLIAM BLANC & CIE

(57) **Abrégé**

Un capteur de courant électrique pour la mesure d'un courant (I; la, Ib) par détection du champ magnétique engendré par ce courant comporte au moins une partie de conducteur électrique (6; 6a, 6b), de section transversale essentiellement rectangulaire, ayant des extrémités agencées de façon à permettre la connexion de cette partie de conducteur en série avec deux brins de conducteur portant le courant à mesurer. La partie de conducteur est entourée, sur trois de ses faces latérales, par une partie de circuit magnétique (7) qui comporte des portions d'extrémité (7', 7") ayant des surfaces planes situées essentiellement dans le plan de la quatrième face latérale de ladite partie de conducteur (6). Un détecteur de champ magnétique (3; 24; 26) est disposé en regard de cette quatrième face latérale. La partie de conducteur (6) est réalisée par photo-lithographie et gravure dans une couche d'un matériau électriquement conducteur appliquée sur une première surface d'un élément de support plat (1; 1'; 1") ou sur une ou plusieurs couches intermédiaires ou parties de couches intermédiaires (8, 9, 10, 11) déposées sur ladite surface de cet élément de support. La partie de circuit magnétique (7) est réalisée par photo-lithographie et gravure dans une couche d'un matériau magnétiquement perméable appliquée sur ladite partie de conducteur (6) et sur des parties de ladite première surface de l'élément de support (1; 1', 1") ou d'une couche intermédiaire (8). Le détecteur de champ magnétique (3; 26) est fixé dans ledit élément de support (1; 1', 1") ou sur une seconde surface de cet élément opposée à ladite première surface de celui-ci, ou sur une ou plusieurs couches ou parties de couches intermédiaires (9, 10, 11) déposées sur ladite seconde surface de l'élément de support.

## Description

La présente invention concerne un procédé de fabrication d'un capteur de courant électrique pour la mesure d'un courant par détection du champ magnétique engendré par ce courant, ce capteur comportant au moins une partie de conducteur électrique, de section transversale essentiellement rectangulaire, ayant des extrémités agencées de façon à permettre la connexion de cette partie de conducteur en série avec deux brins de conducteur portant le courant à mesurer, ladite partie de conducteur étant entourée, sur trois de ses faces latérales, par une partie de circuit magnétique qui comporte des portions d'extrémité ayant des surfaces planes situées essentiellement dans le plan de la quatrième face latérale de ladite partie de conducteur, un détecteur de champ magnétique étant disposé en regard de cette quatrième face latérale.

La structure de principe d'un tel capteur a été décrite dans le document EP 0 772 046 A2.

La fabrication des capteurs connus ou proposés jusqu'ici par les procédés usuels conduit à un coût relativement élevé, dû notamment au coût de l'assemblage des différentes parties qui constituent le capteur.

La présente invention vise à fournir un procédé de fabrication adapté à une production de masse, permettant notamment une simplification de l'assemblage et la fabrication d'un grand nombre de capteurs en même temps, de façon à réduire sensiblement le coût de production.

L'invention vise également à fournir des capteurs ayant de très bonnes performances notamment du point de vue de l'étendue du domaine de mesure de l'intensité des courants et de la sensibilité du capteur, tout en présentant une bonne protection contre l'influence de champs magnétiques parasites.

A cet effet, le procédé selon l'invention comporte les particularités mentionnées dans la partie caractérisante de la revendication 1.

Des formes d'exécution particulières du présent procédé font l'objet des revendications 2 à 15.

D'autres caractéristiques, buts et avantages de l'invention ressortiront plus clairement de la description donnée ci-après de différents exemples de mise-en-oeuvre du présent procédé, illustrés dans les dessins annexés dans lesquels:
la Fig. 1 est une vue en coupe transversale schématique de la structure d'un capteur de courant réalisé selon l'invention;
la Fig. 2 est une vue de dessus d'un capteur du type de celui de la Fig. 1, dans laquelle certaines parties ont été arrachées;
la Fig. 3 est une vue de dessus d'un capteur réalisé de façon similaire à celui de la Fig. 2, mais conçu pour la mesure différentielle de deux courants;
la Fig. 4 est une vue en perspective partielle d'une plaque de support pour la réalisation d'une multitude de capteurs selon l'invention, à un stade intermédiaire de la fabrication; et
les Figures 5 à 8 sont des coupes transversales schématiques de différentes structures de capteurs réalisés selon l'invention.

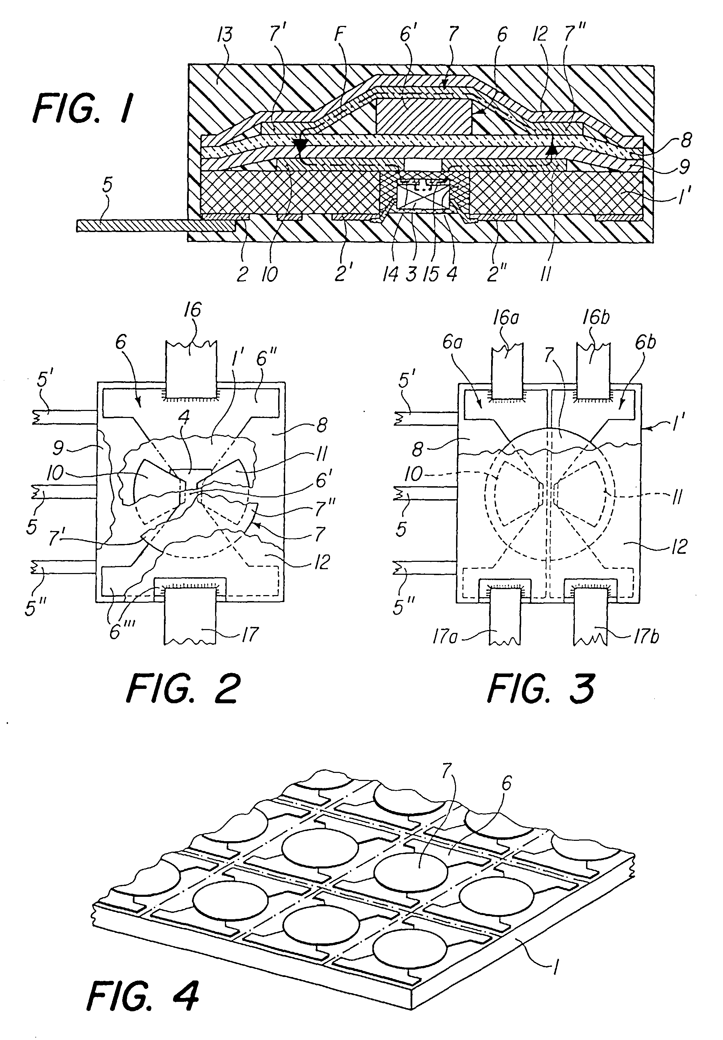

Comme le montre le schéma de principe de la Fig. 1, un capteur fabriqué selon l'invention comporte un élément de support 1', tel que par exemple une plaque de circuit imprimé ou une bande souple, présentant sur une surface des parties métallisées 2 qui forment notamment des pistes de connexion électrique. Dans l'exemple de la Fig. 1, l'élément de support sous forme d'une plaque 1' présente une ouverture dans laquelle est logé un détecteur de champ magnétique 3, tel qu'un détecteur à effet Hall, encapsulé dans un boîtier 4 d'un type disponible dans le commerce. Le détecteur 3 est fixé et connecté par soudure à des parties métallisées telles que 2', 2", qui sont reliées par des pistes de connexion à des connecteurs tels que 5, 5', 5" devant être soudés sur les parties métallisées correspondantes, telles que 2.

Dans les Figures 1 et 2, une partie de conducteur électrique dans laquelle on fait passer un courant I à mesurer, est désignée dans son ensemble par la référence 6. Cette partie de conducteur, de forme plate, à section essentiellement rectangulaire, présente un rétrécissement dans le sens perpendiculaire à la direction du courant I circulant entre des connecteurs ou brins de conducteurs 16 et 17 qui seront soudés sur des extrémités opposées de la partie 6. Cette partie 6 comporte ainsi une portion 6', de section et de longueur réduites, dans laquelle la densité de courant est sensiblement plus élevée que dans des portions 6" et 6"' situées en amont et en aval de la portion 6' et qui permettent, grâce à leur surface relativement grande, la dissipation de la chaleur produite par le courant.

La portion 6' et les zones voisines de la partie de conducteur 6 sont entourées, sur trois de leurs faces latérales, par une partie de circuit magnétique 7 dont le bord est, dans l'exemple représenté, essentiellement circulaire. La partie de conducteur 6 est collée sur une couche d'isolation électrique 8 et la partie de circuit magnétique 7 est collée, d'une part, sur la partie 6 et, d'autre part, le long de deux portions périphériques 7', 7" sur cette couche d'isolation électrique 8. Sous la couche 8 se trouve une couche de blindage électrique 9, destinée à être reliée à la masse. Entre cette couche de blindage 9 et la plaque de support 1' sont disposées deux parties de concentration du flux magnétique désignées par 10 et 11 dont la forme est essentiellement celle de deux trapèzes dont les petites bases sont placées en regard l'une de l'autre, les grandes bases pouvant avoir approximativement la forme d'arcs de cercle tels que représentés à la Fig. 2.

Le circuit magnétique constitué par la partie 7 et les parties 10 et 11 présente un entrefer entre lesdites petites bases, cet entrefer étant placé au voisinage du détecteur 3 de façon que le champ magnétique produit par le courant I influence ce détecteur. La Fig. 1 montre en particulier l'utilisation d'un détecteur du type muni d'éléments concentrateurs de flux intégrés qui permettent d'augmenter la sensibilité du détecteur au courant à mesurer par la récupération du flux de fuite entre les parties 10 et 11. Une ligne de flux moyenne F tracée en traits mixtes indique le passage du flux magnétique dans le capteur.

En ce qui concerne les formes et les dimensions respectives des parties 7, 10 et 11 du circuit magnétique du capteur, il est à noter que la partie 7 a une forme circulaire ou elliptique recouvrant au moins les parties 10 et 11 de manière à assurer un bon blindage vis-à-vis de champs magnétiques extérieurs. Une plus grande largeur de la partie 7 dans le sens transversal par rapport à la direction du courant, telle qu'elle est obtenue par la forme d'une ellipse dont le grand axe est perpendiculaire à la direction du courant, augmente encore la sensibilité du capteur. D'un autre côté, une plus grande longueur de la partie 7 dans le sens du courant procure un seuil de saturation plus élevé et, par conséquent, permet de mesurer de plus fortes intensités de courant. Dans la pratique, on recherchera un compromis entre ces deux tendances pour un cas d'application donné.

La Fig. 3 montre la structure d'un capteur destiné à la mesure différentielle de deux courants la et Ib de sens contraires. Dans ce cas, la partie 6 est divisée en deux parties 6a et 6b séparées par une fente dans la direction des courants et isolées électriquement l'une de l'autre, par exemple par une couche de lacque isolante. Les parties 6a et 6b sont reliées, respectivement, à des connecteurs 16a, 17a et 16b, 17b. Pour le reste, la structure du capteur est analogue à celle de la Fig. 2 et les mêmes chiffres de référence désignent des parties correspondantes. Le détecteur magnétique mesure le champ résultant de la différence entre les courants injectés dans chacune des parties 6a et 6b.

Le présent procédé de fabrication de capteur de courant consiste à réaliser, sur un support tel qu'une plaque de circuit imprimé, les différents éléments par dépôt de couches successives, de manière à former une structure de sandwich, par exemple selon la Fig. 1. Dans la pratique, on réalise une multitude de capteurs simultanément, par exemple sur une plaque de support principale 1, telle que montrée à la Fig. 4. Les différentes couches étant formées, on découpe l'ensemble selon les lignes en traits mixtes de façon que les capteurs individuels auront comme plaque de support 1' la portion correspondante de la plaque 1. Les détecteurs peuvent être montés avant ou après le découpage de la plaque de support principale. Les connecteurs tels que 5, 5', 5" sont soudées sur les métallisations 2, s'il y a lieu, puis les capteurs sont enrobés d'une résine d'encapsulation 13 assurant l'isolation électrique ainsi que la stabilité et la protection mécaniques du dispositif. Cette résine peut également pénétrer dans des espaces creux restant à l'intérieur du capteur après la formation des différentes couches.

Les couches dans lesquelles une forme spécifique des parties du capteur doit être réalisée, telles que les parties 7, 10 et 11 constituant le circuit magnétique, la couche de blindage magnétique 12 et la partie de conducteur 6, sont traitées par photo-lithographie et gravure selon une technique usuelle. La forme définitive des autres couches est obtenue lors de la découpe du sandwich.

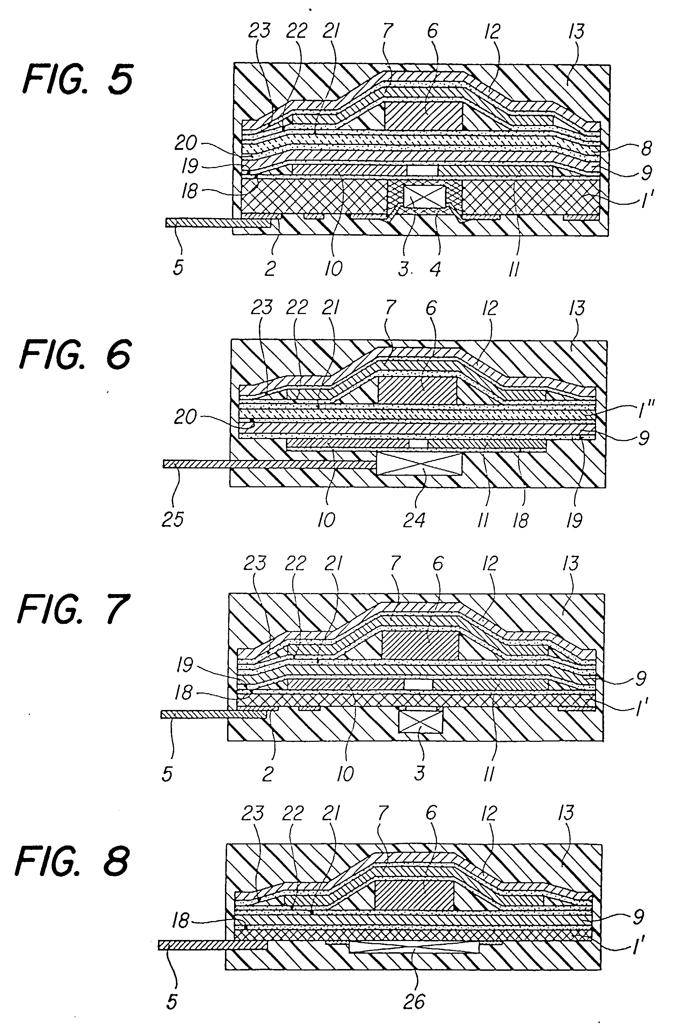

Les figures 5 à 8 montrent différents exemples de structures de capteurs réalisés selon la présente invention. Dans ces figures, les parties analogues et notamment celles décrites à la Fig. 1 ont été désignées par les mêmes chiffres de référence et leur description ou fonction n'a pas été répétée chaque fois.

L'exemple de la Fig. 5 correspond à la structure de la Fig. 1, mais montre en outre les différentes couches adhésives utilisées. Ainsi, la couche adhésive 18 permet de coller la couche de matériau ferromagnétique dans laquelle seront formées les parties 10 et 11 sur la plaque de support 1' et les couches adhésives 19, 20 et 21 assurent, respectivement, la fixation par collage de la couche de blindage électrique 9 sur les parties 10 et 11, puis successivement la fixation de la couche d'isolation électrique 8 et celle de la couche pour la formation de la partie de conducteur 6, les unes sur les autres. Ensuite, on applique, par l'intermédiaire d'une couche adhésive 22, la couche dans laquelle sera formée la partie 7 sur la partie 6. Enfin, la couche de blindage magnétique extérieure est appliquée par l'intermédiaire d'une couche adhésive 23.

Dans l'exemple de la Fig. 6, on utilise une plaque de support 1" en un matériau isolant et sur laquelle les couches pour la formation de la partie de conducteur 6 et de la partie de circuit magnétique 7 ainsi que la couche de blindage 12 sont appliquées les unes sur les autres, comme précédemment. La couche pour la formation des parties de concentration du flux 10 et 11 est collée sur la surface opposée de la plaque 1". Enfin, un détecteur 24 encapsulé dans un boîtier est collé sur les parties 10 et 11. Les connecteurs 25 sortant du boîtier sont maintenus en place lors de l'encapsulation dans la résine 13.

La Fig. 7 montre l'exemple du montage d'un détecteur en forme de puce par "flip chip" sous une plaque de circuit imprimé 1' contenant des pistes de connexion 2.

L'exemple de la Fig. 8 utilise un détecteur constitué par un élément magnéto-résistif ferromagnétique 26 qui sert également à fermer le circuit magnétique du capteur.

Il ressort de ce qui précède que dans toutes les formes de mise en oeuvre visées, l'invention permet la fabrication à trais faible coût de capteurs de courant performants, notamment grâce à une optimisation de la forme et des dimensions des parties constitutives de ces capteurs. Ceux-ci ont ainsi un large champ d'application, par example dans les dispositifs de commande et de surveillance de moteurs électriques, dans les dispositifs de mesure d'énergie, les fusibles électroniques, etc.

## Revendications

1. Procédé de fabrication d'un capteur de courant électrique pour la mesure d'un courant (I; Ia, Ib) par détection du champ magnétique engendré par ce courant, ce capteur comportant au moins une partie de conducteur électrique (6; 6a, 6b), de section transversale essentiellement rectangulaire, ayant des extrémités agencées de façon à permettre la connexion de cette partie de conducteur en série avec deux brins de conducteur portant le courant à mesurer, ladite partie de conducteur étant entourée, sur trois de ses faces latérales, par une partie de circuit magnétique (7) qui comporte des portions d'extrémité (7', 7") ayant des surfaces planes situées essentiellement dans le plan de la quatrième face latérale de ladite partie de conducteur (6), un détecteur de champ magnétique (3; 24; 26) étant disposé en regard de cette quatrième face latérale, caractérisé en ce que
- l'on réalise ladite partie de conducteur (6) par photo-lithographie et gravure dans une couche d'un matériau électriquement conducteur appliquée sur une première surface d'un élément de support plat (1; 1'; 1") ou sur une ou plusieurs couches intermédiaires ou parties de couches intermédiaires (8, 9, 10, 11) déposées sur ladite surface de cet élément de support;
- l'on réalise ladite partie de circuit magnétique (7) par photo-lithographie et gravure dans une couche d'un matériau magnétiquement perméable appliquée sur ladite partie de conducteur (6) et sur des parties de ladite première surface de l'élément de support (1; 1', 1") ou d'une couche intermédiaire (8); et
- l'on fixe ledit détecteur de champ magnétique (3; 26) dans ledit élément de support (1; 1', 1") ou sur une seconde surface de cet élément opposée à ladite première surface de celui-ci, ou sur une ou plusieurs couches ou parties de couches intermédiaires (9, 10, 11) déposées sur ladite seconde surface de l'élément de support.

2. Procédé selon la revendication 1 pour la fabrication d'un capteur comportant des parties de concentration du flux magnétique (10, 11) plates, disposées, respectivement, au moins partiellement, en regard desdites portions d'extrémité (7', 7") de ladite partie de circuit magnétique, caractérisé en ce que
- l'on réalise lesdites parties de concentration du flux magnétique par photo-lithographie et gravure dans une couche d'un matériau magnétiquement perméable formant une couche intermédiaire entre ledit élément de support (1, 1') et ladite partie de conducteur (6).

3. Procédé selon la revendication 1 pour la fabrication d'un capteur comportant des parties de concentration du flux magnétique (10, 11) plates, disposées, respectivement, au moins partiellement, en regard desdites portions d'extrémité (7', 7") de ladite partie de circuit magnétique, caractérisé en ce que
- l'on réalise lesdites parties de concentration du flux magnétique par photo-lithographie et gravure dans une couche d'un matériau magnétiquement perméable formant une couche intermédiaire entre ledit élément de support (1, 1") et ledit détecteur de champ magnétique (24).

4. Procédé selon l'une des revendications précédentes, caractérisé en ce que
- l'on applique une couche de blindage électrique (9) en un matériau électriquement conducteur comme couche intermédiaire entre ladite partie de conducteur (6) et ledit détecteur de champ magnétique (3; 24; 26).

5. Procédé selon l'une des revendications 1, 2 et 4, caractérisé en ce que
- l'on applique une couche d'isolation électrique (8) comme couche intermédiaire entre ladite partie de conducteur (6) et ledit élément de support ou ladite couche de blindage électrique (9).

6. Procédé selon l'une des revendications précédentes, caractérisé en ce que
- l'on applique une couche de blindage magnétique (12) en un matériau magnétiquement perméable sur ladite partie de circuit magnétique (7).

7. Procédé selon l'une des revendications précédentes, caractérisé en ce que ledit élément de support est une plaque de circuit imprimé ou une bande souple à circuit imprimé.

8. Procédé selon l'une des revendications précédentes, caractérisé en ce que ledit détecteur de champ magnétique (3) est un détecteur à effet Hall muni d'éléments concentrateurs du flux magnétique (14, 15) intégrés dans ledit détecteur.

9. Procédé selon l'une des revendications précédentes, caractérisé en ce que ledit élément de support (1', 1") est une portion d'un élément de support principal (1) pour la fabrication simultanée d'une multitude de capteurs de courant, lesdites couches étant appliquées successivement sur l'une et/ou l'autre des surfaces de cet élément de support et l'ensemble étant découpé en portions correspondant auxdits éléments de support des capteurs individuels.

10. Procédé selon l'une des revendications précédentes, caractérisé en ce que ladite partie de conducteur (6) présente un rétrécissement dans le sens perpendiculaire à la direction du courant afin de concentrer le courant sur une portion (6') de longueur réduite de la partie de conducteur, et que lesdites parties de concentration du flux magnétique (10, 11) ont chacune une forme au moins approximativement trapézoïdale et sont disposées de façon que leurs petites bases soient placées en regard l'une de l'autre face à ladite portion (6') de longueur réduite de la partie de conducteur.

11. Procédé selon l'une des revendications précédentes, caractérisé en ce que ladite partie de circuit magnétique (7) est dimensionnée de façon qu'elle recouvre au moins lesdites parties de concentration du flux (10, 11).

12. Procédé selon l'une des revendications précédentes, caractérisé en ce que l'on réalise ladite partie de circuit magnétique (7) de façon qu'elle présente un bord essentiellement circulaire ou en forme d'ellipse.

13. Procédé selon la revendication 12, caractérisé en ce que ladite partie de circuit magnétique (7) a la forme d'une ellipse dont le grand axe est orienté dans le sens perpendiculaire à la direction du courant.

14. Procédé selon l'une des revendications précédentes pour la fabrication d'un capteur de courant permettant une mesure différentielle de deux courants de sens inverses, caractérisé en ce que
- l'on réalise deux parties de conducteur isolées l'une de l'autre, ladite partie de circuit magnétique (7) et ledit détecteur de champ magnétique (3; 24; 26) étant disposés de façon à être influencés par les courants circulant dans lesdites parties de conducteur.

15. Procédé selon l'une des revendications précédentes, caractérisé en ce que
- l'on enrobe le capteur réalisé, après l'avoir muni de parties de connexion électrique, d'une matière d'encapsulation (13).
